Europäisches Patentamt

European Patent Office

Office européen des brevets

Veröffentlichungsnummer: **0 360 886**
**A1**

## EUROPÄISCHE PATENTANMELDUNG

Anmeldenummer: **88115837.2**

Anmeldetag: **26.09.88**

Int. Cl.5: **G01T 1/00 , H01L 31/10 , H01L 31/02**

Veröffentlichungstag der Anmeldung:
**04.04.90 Patentblatt 90/14**

Benannte Vertragsstaaten:
**DE FR GB**

Anmelder: **Siemens Aktiengesellschaft**
**Wittelsbacherplatz 2**
**D-8000 München 2(DE)**

Erfinder: **Brüning, Horst, Dipl.-Phys. Dr.**
**Moritz 20**
**D-8556 Gössweinstein(DE)**
Erfinder: **Schubert, Wolfgang, Dipl.-Chem. Dr.**
**Fontanestrasse 3**
**D-8520 Erlangen(DE)**

### Röntgendetektor.

Ein Röntgendetektor mit einem Szintillationskörper (16 bis 18) und einer damit in optischem Kontakt stehenden Fotodiode (23 bis 28) soll gegenüber dem Stand der Technik vereinfacht werden, wobei eine hohe Lichtausnutzung gegeben sein soll.

Ein Szintillationskörper (16, 17, 18) ist auf mindestens einer Seite von einer Fotodiode (23 bis 28) aus amorphem, wasserstoffhaltigem Silizium (a-Si:H) in Dünnschichtbauweise bedeckt. Diese Fotodiode (23 bis 28) kann unmittelbar auf der polierten Fläche des Szintillationskörpers (16 bis 18) aufgebracht werden. Es ist aber auch möglich, sie auf einem transparenten Träger aufzubringen, der mit dem Szintillationskörper (16 bis 18) verklebt ist. Die Fotodioden (23 bis 28) können beidseitig auf dem Szintillationskörper (16 bis 18) aufgebracht werden, wobei ihre Signale addiert oder zum Nachweis unterschiedlicher Spektralbereiche der Röntgenstrahlung einzeln erfaßt werden können.

FIG 2

## Röntgendetektor

Es sind z.B. in der Computertomographie und in der Computerradiographie verwendete Röntgendetektoren bekannt, welche einen Szintillationskörper aufweisen, auf dessen Strahlenaustrittsseite (Unterseite) eine in transparentem Kunststoff eingebettete, kristalline Silizium-Fotodiode geklebt ist. Die Verklebung verursacht dabei Lichtverlust durch Reflexion und Streuung. Außerdem ist die Herstellung insbesondere von Arrays auf der Basis dieser Technologie aufwendig.

Der Erfindung liegt die Aufgabe zugrunde, einen Röntgendetektor mit einem Szintillationskörper und einer damit in optischem Kontakt stehenden Fotohalbleiter so auszubilden, daß bei einfacher Fertigung eine optimale Lichtausnutzung erfolgt.

Diese Aufgabe ist erfindungsgemäß dadurch gelöst, daß die Fotohalbleiter ein Fotohalbleiter mit amorphem, wasserstoffhaltigem Silizium ist. Ein solcher Fotohalbleiter, insbesondere eine a-Si:H-Fotodiode, kann direkt auf dem Szintillationskörper in Dünnschichttechnik aufgebracht werden. Er erlaubt die Verwendung nicht glasklarer, insbesondere durchscheinender Szintillator-Materialien, da er eine Steigerung der Lichtausnutzung ermöglicht.

Der nur ca. 1 μm dicke Fotohalbleiter hat eine so geringe Röntgenabsorption, daß er auch auf der Strahleneintrittsseite des Szintillatorkörpers eingebracht werden kann, ohne das relative Signalrauschen zu erhöhen. Wird auf der Strahleneintrittsseite und auf der Strahlenaustrittsseite des Szintillatorkörpers je eine Fotohalbleiter angebracht, so ergibt sich bei Parallelschaltung oder Reihenschaltung zweier einander zugeordneter Fotohalbleiter ein höheres Ausgangssignal als bei Verwendung nur eines Fotohalbleiters pro Kanal oder die Möglichkeit der getrennten Verarbeitung der Ausgangssignale beider Fotohalbleiter eines Kanals zum gesonderten Nachweis unterschiedlicher Spektralbereiche der Röntgenstrahlung.

Die Sandwichbauweise Fotohalbleiter - Szintillationskörper - Fotohalbleiter eröffnet die Möglichkeit, auch Szintillationskörper einzusetzen, die nicht transparent sind wie viele Einkristalle, sondern nur durchscheinend (polykristalline und gesinterte Szintillatoren).

Schließlich erlaubt die a-Si:H-Technologie den Bau großflächiger Arrays, bestehend aus einer Vielzahl separater Fotodioden. Da die Anordnung aus a-Si:H-Fotodioden in Dünnschichttechnik hergestellt wird, erreicht man eine erhebliche Kostensenkung. Neben Fotodioden, die aus a-Si:H hergestellt sind, ist es auch möglich, wasserstoffhaltige Legierungen des amorphen Siliziums zu verwenden, wie z.B. $a\text{-}Si_x\,Ge_y\text{:}\,H$, $a\text{-}Si_x\,C_y\text{:}H$, $a\text{-}Si_x\,N_y\text{:}H$, um die spektrale Empfindlichkeit der Fotodioden an das Szintillationslicht des Szintillators anzupassen (x, y geben die Anteile der entsprechenden Elemente an). Weiterhin kann statt einer Fotodiode ebenso eine Fotowiderstandsstruktur in der beschriebenen Anordnung verwendet werden. Auf diese Weise läßt sich der Signalstrom des Detektors um ein Vielfaches erhöhen.

Die Erfindung ist nachfolgend anhand der Zeichnung näher erläutert. Es zeigen:

Fig. 1 den schematischen Aufbau eines Computertomographen zur Erläuterung des Erfindungsgedankens, und

Fig. 2 bis 4 Ausführungsbeispiele für Röntgendetektoren nach der Erfindung für die Anwendung bei dem Computertomographen gemäß Fig. 1.

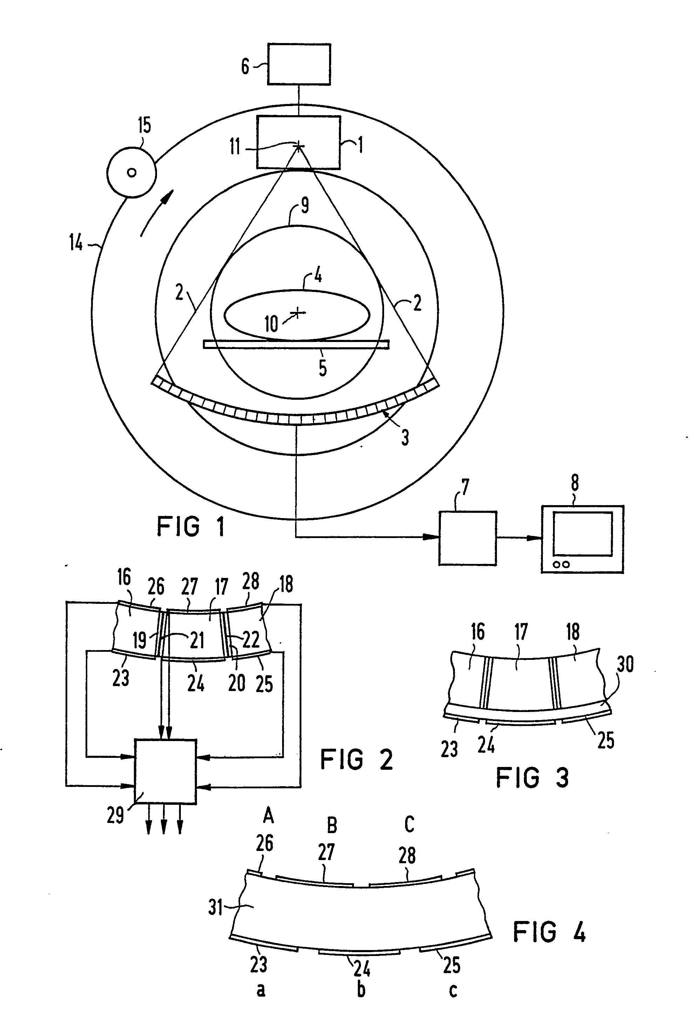

Der Computertomograph gemäß Fig. 1 weist eine Meßeinheit aus einer Röntgenstrahlenquelle 1, die ein fächerförmiges Röntgenstrahlenbündel 2 aussendet, und einem Strahlenempfänger 3 auf, welcher aus einer Reihe von Einzeldetektoren, z.B. aus 512 Einzeldetektoren, besteht. Der zu untersuchende Patient 4 liegt auf einer Patientenliege 5. Zur Abtastung des Patienten 4 wird die Meßeinheit 1, 3 um ein Meßfeld 9, in dem der Patient 4 liegt, um 360° gedreht. Die Drehachse ist mit 10 bezeichnet. Dabei wird die Röntgenstrahlenquelle 1, die von einem Röntgengenerator 6 gespeist wird, gepulst oder mit Dauerstrahlung betrieben. Bei vorbestimmten Winkelpositionen der Meßeinheit 1, 3 werden Sätze von Daten erzeugt, die vom Strahlenempfänger 3 einem Rechner 7 zugeführt werden, welcher aus den erzeugten Datensätzen die Schwächungskoeffizienten vorbestimmter Bildpunkte berechnet und auf einem Sichtgerät 8 bildlich wiedergibt. Auf dem Sichtgerät 8 erscheint demgemäß ein Bild der durchstrahlten Schicht des Patienten 4.

Die Änderung der Richtung des Röntgenstrahlenbündels 2 erfolgt durch Drehung eines Drehkranzes 14, auf dem die Röntgenstrahlenquelle 1 und der Strahlenempfänger 3 angeordnet sind, mit Hilfe einer Drehvorrichtung 15.

Die Fig. 2 zeigt ein Ausführungsbeispiel für den Strahlenempfänger 3, bei dem der Strahlenempfänger 3 aus einer Reihe von Szintillationskörpern 16, 17, 18 gebildet ist, die durch Schlitze 19, 20 voneinander getrennt sind, welche mit einem Reflektormaterial ($TiO_2$, MgO, mit oder ohne Binder) gefüllt sind. In diesem Material ist eine lichtundurchlässige Schicht 21, 22 zur Verhinderung des Übersprechens eingebracht.

Auf den Szintillationskörpern 16, 17, 18 sind direkt a-Si:H-Fotodioden 23, 24, 25 auf der Strahlenaustrittsseite und 26, 27, 28 auf der Strahleneintrittsseite aufgebracht. Hierzu sind die entsprechenden Flächen der Szintillationskörper 16 bis 18 poliert.

Die Szintillationskörper 16 bis 18 bilden zusammen mit den Fotodioden 23 bis 28 ein Array, wie es in der Fig. 1 den Strahlenempfänger 3 bildet.

Die Fig. 2 zeigt eine elektronische Schaltvorrichtung 29, die dem Rechner 7 wahlweise Ausgangssignale zuführt, die durch Parallelschaltung jeweils zweier einander zugeordneter Fotodioden 23, 26; 24, 27; 25, 28 erzeugt werden, oder die die Ausgangssignale der Fotodioden 23 bis 28 einzeln weiterleitet. Dementsprechend wird im ersteren Fall ein hohes Kanalsignal erzeugt, während im zweiten Fall unterschiedliche Spektralbereiche der Röntgenstrahlung nach der Dual Energy-Methode nachgewiesen werden können.

Die Fig. 3 zeigt ein Ausführungsbeispiel, bei dem auf den Szintillationskörpern 16, 17, 18 nur auf der Strahlenaustrittsseite a-Si:H-Fotodioden 23, 24, 25 angeordnet sind. Diese Fotodioden 23, 24, 25 sind jedoch nicht wie bei dem Beispiel gemäß Fig. 2 direkt auf den Szintillationskörpern 16, 17, 18 aufgebracht, sondern auf einer transparenten Schicht 30, z.B. aus Glas, welche mit den Szintillationskörpern 16, 17, 18 durch eine sehr dünne Klebeschicht verklebt ist, welche praktisch keine Streuungen und Signalschwächungen verursacht.

Die Fig. 4 zeigt ein Ausführungsbeispiel, bei dem ein als Scheibe ausgebildeter Szintillationskörper 31 vorgesehen ist, der wieder auf seiner Strahlenaustrittsseite und auf seiner Strahleneintrittsseite mit den a-Si:H-Fotodioden 23, 24, 25, 26, 27, 28 bedeckt ist. Die Fotodioden 23, 24, 25 sind dabei gegenüber den Fotodioden 26, 27, 28 versetzt. Diese Versetzung auf dem als großflächige Scheibe ausgebildeten Szintillationskörper 31 ermöglicht durch Zusammenfassung bzw. Gewichtung der einzelnen Signale eine Erhöhung der Auflösung gegenüber derjenigen, die sich aus der nominellen Teilung ergibt. Die Signalzusammenfassung kann dabei beispielsweise in folgender Weise erfolgen:

$A + \dfrac{a+b}{2}$ = erster Meßwert

$b + \dfrac{A+B}{2}$ = zweiter Meßwert

$B + \dfrac{b+c}{2}$ = dritter Meßwert

Die Szintillationskörper 16, 17, 18, 31 lassen sich einkristallin oder polykristallin durch Schmelzen und Abkühlen, Extrudieren, Sintern mit oder ohne Druckanwendung bei geeigneter Temperatur oder Einbetten des pulverförmigen Szintillationskörpers in einen Binder, der thermoplastisch oder als Mehrkomponentensystem zum Einsatz kommt, herstellen.

Die Erfindung ist in Verbindung mit einem Detektor-Array, das den Strahlenempfänger 3 bildet, beschrieben. Prinzipiell ist sie aber auch bei einem einzelnen Röntgendetektor anwendbar, der nur einen Szintillationskörper aufweist, der mindestens auf einer Seite mit einer a-Si:H-Fotodiode oder allgemein mit einem Fotohalbleiter mit amorphem, wasserstoffhaltigem Silizium bedeckt ist.

## Ansprüche

1. Röntgendetektor mit einem Szintillationskörper (16, 17, 18, 31) und einer damit in optischem Kontakt stehenden Fotohalbleiter (23 bis 28), **dadurch gekennzeichnet,** daß der Fotohalbleiter (23 bis 28) ein Fotohalbleiter mit amorphem, wasserstoffhaltigem Silizium ist.

2. Röntgendetektor nach Anspruch 1, **dadurch gekennzeichnet,** daß der Fotohalbleiter (23 bis 28) direkt auf einer polierten Fläche des Szintillationskörpers (16, 17, 18, 31) aufgebracht ist.

3. Röntgendetektor nach Anspruch 1, **dadurch gekennzeichnet,** daß der Fotohalbleiter (23, 24, 25) auf einer transparenten Schicht (30) aufgebracht ist, welche in optischem Kontakt mit dem Szintillationskörper (16, 17, 18) steht.

4. Röntgendetektor nach einem der Ansprüche 1 bis 3, **dadurch gekennzeichnet,** daß sowohl auf der Strahleneintrittsseite als auch auf der Strahlenaustrittsseite des Szintillationskörpers (16, 17, 18) eine Fotohalbleiter (23 bis 28) angeordnet ist.

5. Röntgendetektor nach einem der Ansprüche 1 bis 4, **dadurch gekennzeichnet,** daß der Szintillationskörper (16, 17, 18, 31) aus einem nicht transparenten Material besteht.

6. Röntgendetektor nach einem der Ansprüche 1 bis 5, **dadurch gekennzeichnet,** daß auf einem großflächigen Szintillationskörper (16, 17, 18, 31) mehrere Fotohalbleiter (23 bis 28) in einer Reihe aufgebracht sind.

7. Röntgendetektor nach Anspruch 6, **dadurch gekennzeichnet,** daß der Szintillationskörper (16, 17, 18) Schlitze (19, 20) aufweist, die den Szintillationskörper (16, 17, 18) in Abschnitte teilen, von denen jedem eine Fotodiode (23 bis 28) zugeordnet ist.

8. Röntgendetektor nach Anspruch 7, **dadurch gekennzeichnet,** daß die Schlitze (19, 20) mit Reflektormaterial gefüllt sind.

9. Röntgendetektor nach Anspruch 8, **dadurch gekennzeichnet,** daß in das Reflektormaterial eine lichtundurchlässige Schicht (21, 22) eingebracht ist.

10. Röntgendetektor nach den Ansprüchen 4 und 6, **dadurch gekennzeichnet,** daß die Fotohalbleiter (23, 24, 25) auf einer Seite des Szintillationskörpers (31) gegenüber denen (26, 27, 28) der anderen Seite versetzt sind.

FIG 1

FIG 2

FIG 3

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| X,Y | EP-A-0 275 446 (HEIMANN GmbH) * Zusammenfassung; Spalte 3, Zeile 52 - Spalte 4, Zeile 57; Figuren * --- | 1-3,5-9 | G 01 T 1/00 H 01 L 31/10 H 01 L 31/02 |
| Y | EP-A-0 036 530 (SIEMENS AG) * Zusamenfassung; Seite 2, Zeile 25 - Seite 4, Zeile 22; Figuren * --- | 1-3,6 | |
| Y | US-A-4 734 588 (Y. AKAI) * Zusammenfassung; Spalte 2, Zeilen 23-51; Spalte 3, Zeilen 41-61; Figuren * --- | 1-3,5-9 | |
| A | GB-A-2 005 405 (MACHLETT LABORATORIES) * Zusammenfassung; Seite 2, Zeilen 32-96; Seite 3, Zeilen 10-24; Figuren 8-10 * ----- | 4,10 | |

RECHERCHIERTE
SACHGEBIETE (Int. Cl.3)

G 01 T
H 01 L

Der vorliegende Recherchenbericht wurde für alle Patentansprüche erstellt

| Recherchenort | Abschlußdatum der Recherche | Prüfer |
|---|---|---|
| DEN HAAG | 16-05-1989 | DATTA S. |